# FASCICULE DE BREVET EUROPEEN

(11) **EP 1 041 711 B1**
(45) Date de publication et mention de la délivrance du brevet: **14.11.2007**
(21) Numéro de dépôt: 00201046.0
(22) Date de dépôt: 21.03.2000
(51) Int. Cl.: H03F 1/02

(54) **Appareil électronique comportant un amplificateur de puissance**
Elektronisches Gerät mit einem Leistungsverstärker
Electronic device with a power amplifier

(30) Priorité: 30.03.1999 FR 9903971
(43) Date de publication de la demande: 04.10.2000
(73) Titulaire: NXP B.V., 5656 AG Eindhoven (NL)
(72) Inventeur: Chabas, Jean Alain, 75008 Paris (FR)
(74) Mandataire: Pennings, Johannes

(56) Documents cités:
- EP-A- 0 558 793
- GB-A- 2 260 871
- US-A- 5 825 248

## Description

La présente invention concerne un appareil électronique comportant : un amplificateur de puissance pour fournir une puissance d'émission à une charge, formé d'une entrée pour recevoir un signal à transmettre, d'un étage final muni d'une entrée d'alimentation pour recevoir une puissance d'alimentation, d'un circuit de mesure pour mesurer une grandeur électrique appliquée à ladite entrée d'alimentation, d'un circuit d'alimentation variable commandé à partir dudit circuit de mesure pour contrôler ladite puissance d'émission, ledit circuit d'alimentation variable comportant : un premier circuit d'alimentation muni d'une première entrée de commande pour définir sa tension de sortie, un circuit d'alimentation série qui est monté à la suite dudit premier circuit d'alimentation et qui est muni d'une entrée de commande série pour définir sa tension de sortie.

L'invention concerne aussi un amplificateur convenant à un tel appareil.

L'invention trouve des applications notamment dans les appareils de radiotéléphonie mobiles pour lesquels on exige des consommations de courant réduites en vue d'augmenter la durée de la décharge de l'accumulateur qui alimente ces appareils. L'amplificateur d'émission d'onde haute fréquence consomme beaucoup d'énergie. Il y a donc intérêt à utiliser des classes d'amplification à haut rendement. C'est le cas de la classe D et autres.

Le document européen EP0558793 décrit un amplificateur de ce type mais de classe A, confronté au problème de réaliser une compression de niveau. Un autre document «La post régulation», Electronique, CEP Communication, Paris, Décembre 1990, ISSN 1157-1152, XP000177316, décrit un système d'alimentation comportant une alimentation à découpage suivie d'un régulateur de tension continue. Ces documents ne mentionnent pas le problème que la présente invention se propose de résoudre. En effet l'invention se propose de fixer la puissance de sortie d'un amplificateur en classe D. La puissance de sortie de ce genre d'amplificateur de classe D est directement reliée à la tension d'alimentation, ce qui n'est pas le cas pour l'amplificateur décrit dans le premier document où l'on est confronté à fixer des seuils afin d'assurer une bonne linéarité pour certains niveaux de signaux à amplifier et aussi pour assurer la compression de signaux. D'autre part pour que le régulateur de tension continue puisse effectuer sa fonction de manière satisfaisante il y a lieu de fixer avec précision une valeur minimale. L'autre document mentionne le fait que sa tension de sortie est déterminée par la variation de la valeur d'une résistance, ce qui ne permet pas de réaliser un asservissement simple de la tension de sortie et ne donne donc pas d'indication sur la manière dont on peut faire varier simplement sa tension de sortie.

La présente invention propose un appareil du genre mentionné dans le préambule destiné à amplifier des signaux en classe D facilement réglable en puissance tout assurant de bonnes performances de linéarité et d'économie en puissance.

La présente invention propose un appareil du genre mentionné dans le préambule qui présente une consommation réduite du circuit de commande et une grande immunité aux bruits.

Pour cela, un tel appareil est remarquable en ce que le premier circuit d'alimentation est un circuit d'alimentation du type à découpage, en ce qu'il est prévu un circuit d'asservissement pour que la différence de tension entre l'entrée et la sortie du circuit d'alimentation série soit minimale, en agissant sur la première entrée de commande, et en ce que le circuit d'asservissement comporte un circuit de soustraction élaborant la différence de tension entre la tension d'entrée et la tension de sortie du circuit d'alimentation série, et un comparateur pour comparer ladite différence de tension à une tension de consigne pur agir sur ladite première entrée de commande.

L' idée de l'invention est d'utiliser une alimentation à découpage dont le rendement est des meilleurs.

Une caractéristique importante de l'invention consiste en ce que ledit circuit d'alimentation variable comporte en outre un circuit d'alimentation série qui est muni d'une entrée de commande série pour définir sa tension de sortie et auquel est rattaché un circuit d'asservissement pour que la différence de tension entre l'entrée et la sortie du circuit d'alimentation série soit minimale. Cette caractéristique fait que le transistor ballast qui est contenu dans les circuits d'alimentation série travaille à saturation et donc consomme peu d'énergie. En outre on obtient l'avantage que les bruits de découpage de l'alimentation à découpage sont filtrés sans trop de consommation d'énergie.

La description suivante, faite en regard des dessins ci-annexés, le tout donné à titre d'exemple non limitatif, fera bien comprendre comment l'invention peut être réalisée.
La figure 1 montre un appareil conforme à l'invention.
La figure 2 montre le schéma de réalisation de l'amplificateur de l'appareil de la figure 1.
La figure 3 montre un schéma plus détaillé de l'amplificateur de l'invention.
La figure 4 explicite le circuit de prélèvement de courant.
La figure 5 explicite la structure d'un amplificateur travaillant en classe D.

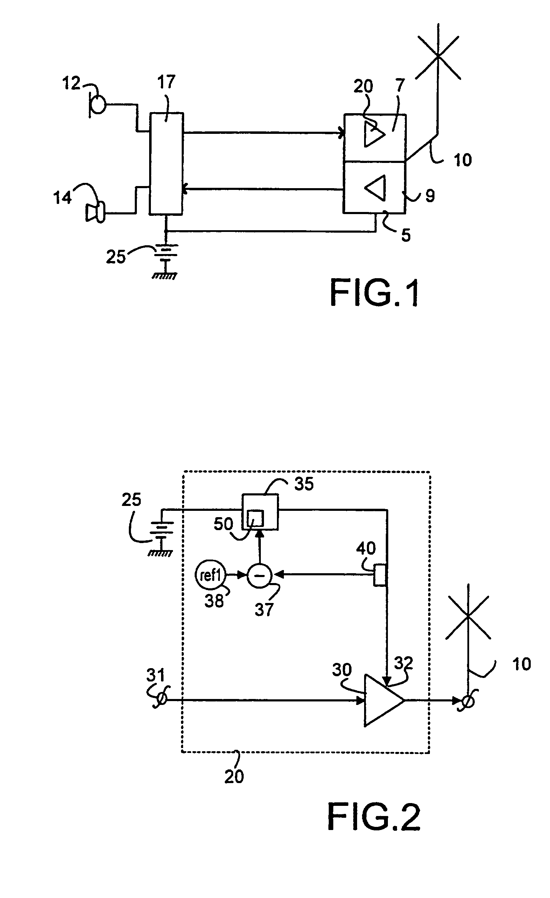

A la figure 1, on a représenté un appareil électronique conforme à l'invention. Cet appareil est un émetteur-récepteur tel une radio mobile dans un réseau cellulaire. Il se compose d'un ensemble d'émission-réception 5 comportant une partie émission 7 et une partie réception 9 pour émettre des signaux et pour en recevoir en utilisant une antenne 10. Les signaux à émettre proviennent notamment d'un microphone 12 et ceux qui sont reçus sont destinés notamment à un haut-parleur 14. Un organe de traitement 17 assure l'interface entre les signaux à basse fréquence concernant le microphone 12 et le haut-parleur 14 et l'ensemble 5. Le tout est alimenté par un accumulateur 25.

L'ensemble d'émission-réception comporte un amplificateur haute fréquence 20 fournissant des signaux de puissance relativement élevée.

Cet amplificateur 20 est montré en détail à la figure 2. Il se compose d'un étage final 30 destiné à amplifier les signaux appliqués à sa borne d'entrée 31 pour les fournir à l'antenne 10. Cet amplificateur est alimenté, par son entrée d'alimentation 32, à partir de l'accumulateur 25, suivi d'un circuit de régulation d'alimentation variable 35. Cette alimentation est commandée par un circuit comparateur 37 qui mesure le courant débité par l'étage final 30 pour le comparer à une valeur de référence "ref1" fournie par un premier générateur de tension de référence 38. Un circuit de prélèvement de courant 40 prélève une fraction bien définie du courant de l'alimentation de cet étage final. Ce courant définit la puissance fournie par cet étage final.

Conformément à l'invention, le circuit d'alimentation variable 35 comporte un circuit d'alimentation à découpage 50.

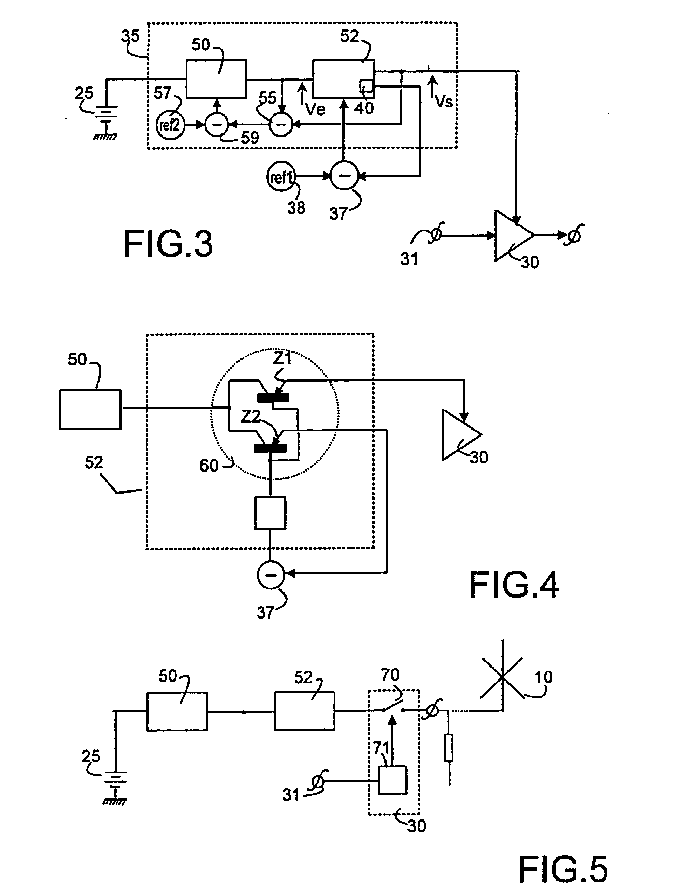

La figure 3 montre plus en détail la réalisation de l'invention. Au circuit d'alimentation à découpage 50 dont l'entrée est directement reliée à une borne de l'accumulateur 25 est associé un circuit d'alimentation série 52. On profite de la structure de ce circuit 52 pour réaliser le circuit de prélèvement de courant d'une manière qui sera explicitée à l'aide de la figure 4.

Selon le mode de réalisation représenté à la figure 3, le circuit d'alimentation à découpage 50 reçoit une tension de commande de découpage qui dépend de la différence des tensions « Ve » et « Vs » existant entre l'entrée et la sortie du circuit d'alimentation série 52. Cette différence est élaborée par un circuit de soustraction 55. La tension de sortie de ce circuit 55 est comparée à une tension de référence "ref2" fournie par un deuxième générateur de tension de référence 57 au moyen d'un circuit de soustraction 59 qui fournit une tension à la commande de tension de découpage du circuit d'alimentation 50. Le générateur 57 fournit une tension suffisamment basse pour éviter une dissipation d'énergie par le circuit d'alimentation série 52 puisqu'il fixe à une faible valeur la différence « Vs-Ve ». La tension de sortie « Vs » du circuit d'alimentation série est fixée, comme cela a déjà été dit, par le circuit comparateur 37.

Ainsi par ce double asservissement, le premier qui implique le circuit d'alimentation à découpage 50, on obtient un bon rendement énergétique et le second qui implique le circuit d'alimentation série 52, on élimine les perturbations de découpage du circuit d'alimentation 50, ceci sans dépenser beaucoup d'énergie car la tension entre son entrée et sa sortie est gardée faible.

La figure 4 montre comment le circuit de prélèvement 40 est constitué. La référence 60 indique le transistor ballast du circuit série. Ce transistor présente une pluralité de zones d'émetteur ; la plus grande partie Z1 est utilisée pour alimenter l'amplificateur 30 et une seule zone Z2 est utilisée pour être appliquée au comparateur 37.

La figure 5 représente schématiquement le fonctionnement d'un amplificateur 30 fonctionnant en classe D. Un tel amplificateur est constitué à partir d'un circuit interrupteur 70 qui est commandé en ouverture-fermeture au moyen d'un circuit de commande 71. Ainsi, l'interrupteur est ouvert et fermé en fonction des signaux appliqués sur la borne d'entrée 31. Ainsi, la tension d'alimentation est appliquée, via les circuits d'alimentation 50 et 52, directement sur la charge que constitue l'antenne 10.

Grâce à l'invention, on s'est rendu maître de la puissance fournie par l'amplificateur 30. Cette puissance est définie par le générateur 38 qui peut fournir des références variables en fonction des besoins.

## Revendications

1. °) Appareil électronique comportant :
- un amplificateur de puissance pour fournir une puissance d'émission à une charge, formé :
- d'une entrée (31) pour recevoir un signal à transmettre
- d'un étage final (30) muni d'une entrée d'alimentation pour recevoir une puissance d'alimentation (Vs),
- d'un circuit de mesure (40) pour mesurer une grandeur électrique appliquée à ladite entrée d'alimentation,
- d'un circuit d'alimentation variable (35) commandé à partir dudit circuit de mesure pour contrôler ladite puissance d'émission,
ledit circuit d'alimentation variable (35) comportant :
- un premier circuit d'alimentation (50) muni d'une première entrée de commande pour définir sa tension de sortie.
- un circuit d'alimentation série (52) qui est monté à la suite dudit premier circuit d'alimentation et qui est muni d'une entrée de commande série pour définir sa tension de sortie appareil **caractérisé en ce que** le premier circuit d'alimentation est un circuit d'alimentation du type à découpage (50), **en ce qu'**il est prévu un circuit d'asservissement pour que la différence de tension entre l'entrée et la sortie du circuit d'alimentation série soit minimale, en agissant sur la première entrée de commande,
et **en ce que** le circuit d'asservissement comporte un circuit de soustraction (55) élaborant la différence de tension entre la tension d'entrée et la tension de sortie du circuit d'alimentation série, et un comparateur (59) pour comparer ladite différence de tension à une tension de consigne (ref 2) pur agir sur ladite première entrée de commande.

2. °) Appareil selon la revendication 1 **caractérisé en ce que** l'amplificateur de puissance est formé par un interrupteur dont la commande d'ouverture et/ou de fermeture constitue ladite entrée pour signal à recevoir et qui est inséré entre la sortie du circuit d'alimentation et la charge.

3. °) Amplificateur convenant à un appareil selon l'une des revendications 1 à 2.

## Claims

1. An electronic device comprising:
- a power amplifier for supplying a transmit power to a load, formed by:
- an input (31) for receiving a signal to be transmitted,
- a final stage (30) having a supply input for receiving a supply power (Vs),
- a measuring circuit (40) for measuring an electrical magnitude applied to said supply input,
- a variable power supply circuit (35) controlled by said measuring circuit for controlling said transmit power,
the variable power supply circuit comprising:
- a first power supply circuit (50) having a first control input for defining its output voltage,
a series power supply circuit (52) that is mounted after said first power supply circuit and which has a series control input for defining its output voltage,
which device is **characterized in that** the first power supply circuit is a switched-mode power supply circuit (50), **in that** it comprises a slaved circuit so that the voltage difference between the input and the output of the series power supply circuit is minimized by acting on the first control input,
and **in that** the slaved circuit comprises a subtracter circuit (55) producing the difference in voltage between the input voltage and the output voltage of the series power supply circuit, and a comparator (59) for comparing said voltage difference to a reference voltage (ref 2) so as to act on said first control input.

2. A device as claimed in claim 1, **characterized in that** the power amplifier is formed by a switch whose command to open and/or close forms said input for the signal to be received and which is inserted between the output of the power supply circuit and the load.

3. An amplifier suitable for a device as claimed in any one of the claims 1 to 2.

## Patentansprüche

1. Elektronisches Gerät, umfassend:
- einen Leistungsverstärker, der einer Last eine Sendeleistung zuführt, gebildet aus:
- einem Eingang (31) zum Empfangen eines zu übertragenden Signals,
- einer Endstufe (31), die mit einem Versorgungseingang zum Empfangen einer Versorgungsleistung (Vs) versehen ist,
- einem Messkreis (40) zum Messen einer elektrischen Größe, die an den Versorgungseingang angelegt wird,
- einem variablen Versorgungskreis (35), der von dem Messkreis aus gesteuert wird, um die Sendeleistung zu regeln,
wobei der variable Versorgungskreis (35) umfasst:
- einen ersten Versorgungskreis (50), der mit einem ersten Steuereingang versehen ist, um seine Ausgangsspannung zu definieren,
- einen seriellen Versorgungskreis (52), der nach dem ersten Versorgungskreis montiert ist und der mit einem seriellen Steuereingang versehen ist, um seine Ausgangsspannung festzulegen,
**dadurch gekennzeichnet, dass** der erste Versorgungskreis ein Versorgungskreis mit Verschnitt (50) ist, dass ein Regelungsstromkreis vorgesehen ist, damit der Spannungsunterschied zwischen dem Eingang und dem Ausgang des seriellen Versorgungskreises minimal ist, indem auf den ersten Steuereingang gewirkt wird,
und dass der Regelungsstromkreis einen Subtraktionskreis (55), welcher den Spannungsunterschied zwischen der Eingangsspannung und der Ausgangsspannung des seriellen Versorgungskreises eruiert, und einen Komparator (59) zum Vergleichen des Spannungsunterschieds mit einer Sollspannung (ref 2), um auf den ersten Steuereingang zu wirken, umfasst.

2. Gerät nach Anspruch 1, **dadurch gekennzeichnet, dass** der Leistungsverstärker durch einen Schalter gebildet ist, dessen Öffnungs- und/oder Schließsteuerung diesen Empfangssignaleingang ausmacht und der zwischen dem Ausgang des Versorgungskreises und der Last eingefügt ist.

3. Verstärker, passend zu einem Gerät nach einem der Ansprüche 1 bis 2.
